# EUROPEAN PATENT APPLICATION

(11) **EP 4 796 999 A1**
(43) Date of publication of application: **26.08.2026**
(21) Application number: 25159434.7
(22) Date of filing: 21.02.2025
(51) Int. Cl.: G03F 7/00, G05B 19/416

(54) **EXPOSURE METHOD AND APPARATUS**

(71) Applicant: ASML Netherlands B.V., 5500 AH Veldhoven (NL)
(72) Inventor: NAGY, István, 5500 AH Veldhoven (NL); VANDEVELDE, Benjamin, Marcus, Sebastiaan, 5500 AH Veldhoven (NL); MATTAAR, Thomas, Augustus, 5500 AH Veldhoven (NL); HUIBERTS, Sjoerd, Martijn, 5500 AH Veldhoven (NL); VAN DEN NIEUWELAAR, Norbertus, Josephus, Martinus, 5500 AH Veldhoven (NL)
(74) Representative: ASML Netherlands B.V.

(57) **Abstract**

A substrate exposure method comprising performing, using an exposure apparatus, at least two processes simultaneously. Each process involves an activation of a respective actuator of the exposure apparatus, the method comprises in a first phase: determining, for each process, if the process is time critical or non-time critical,
determining an acceleration parameter for each actuator, comprising: reducing the acceleration parameter to a value lower than a respective maximum if the process is non-time critical.

In a second phase an acceleration time profile for each actuator is adjusted using the determined acceleration parameter for the respective actuator;

In a third phase the at least two processes are performed by the exposure apparatus, using the adjusted acceleration time profile for each actuator.

## Description

### FIELD

The present invention relates to a method of processing a substrate and to an exposure apparatus, comprising a control device configured to control a processing of the substrate.

### BACKGROUND

In semiconductor device manufacturing processes, apparatuses can be used to process and/or assess objects such as a substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged-particle radiation with an object such as a substrate or a patterning device. An inspection apparatus and a metrology apparatus are examples of such assessment apparatuses and may be used to detect particles or measure a critical dimension, for example.

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

**In** semiconductor manufacturing, it is desirable to increase a throughput in terms of number of substrates processed per unit of time. The increased throughput tends to translate into higher processing velocities of processing of a substrate. Due to the higher processing velocities, actuator power consumption may tend to increase which may result in an increase in overall power consumption of the exposure apparatus.

### SUMMARY

Considering the above, it is an object of the invention to reduce a power consumption associated with the semiconductor manufacturing.

According to an embodiment of the invention, there is provided a substrate exposure method comprising performing, using an exposure apparatus, at least two processes simultaneously, wherein each process involves an activation of a respective actuator of the exposure apparatus, the method comprising:
- in a first phase:
   determining, for each process, if the process is time critical or non-time critical,
   determining an acceleration parameter for each actuator, comprising:
      reducing the acceleration parameter to a value lower than a respective maximum if the process is non-time critical;
         - in a second phase
      adjusting an acceleration time profile for each actuator using the determined acceleration parameter for the respective actuator;
- in a third phase
   performing the at least two processes by the exposure apparatus, using the adjusted acceleration time profile for each actuator.

According to a further embodiment of the invention, there is provided an exposure apparatus configured to perform at least two processes simultaneously, wherein each process involves an activation of a respective actuator of the exposure apparatus, the exposure apparatus comprising a control device configured to:
- in a first phase:
   determine, for each process, if the process is time critical or non-time critical,
   determine an acceleration parameter for each actuator, comprising:
      reduce the acceleration parameter to a value lower than a respective maximum if the process is non-time critical;
         - in a second phase
      adjust an acceleration time profile for each actuator using the determined acceleration parameter for the respective actuator;
- in a third phase
   perform the at least two processes by the exposure apparatus, using the adjusted acceleration time profile for each actuator.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus according to an embodiment of the invention;
- Figure 2 depicts a detailed view of a part of the lithographic apparatus of Figure 1;
- Figure 3 schematically depicts a position control system as part of a positioning system according to an embodiment of the invention;
- Figure 4 schematically depicts a plurality of processes as may be performed by an exposure apparatus;
- Figure 5 schematically depicts an acceleration time profile determination according to an embodiment;
- Figure 6 schematically depicts a time diagram of position, velocity and acceleration of actuators of the exposure apparatus; and
- Figure 7 schematically depicts a part of a stage trajectory according to an embodiment.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

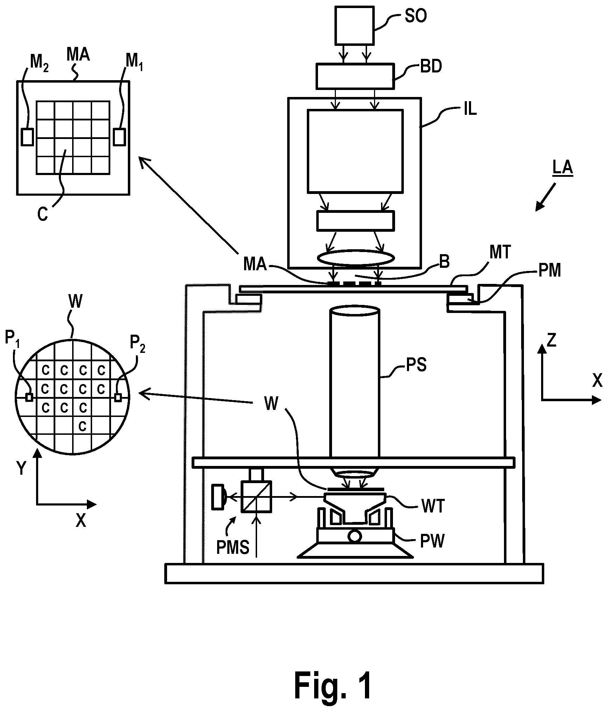

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

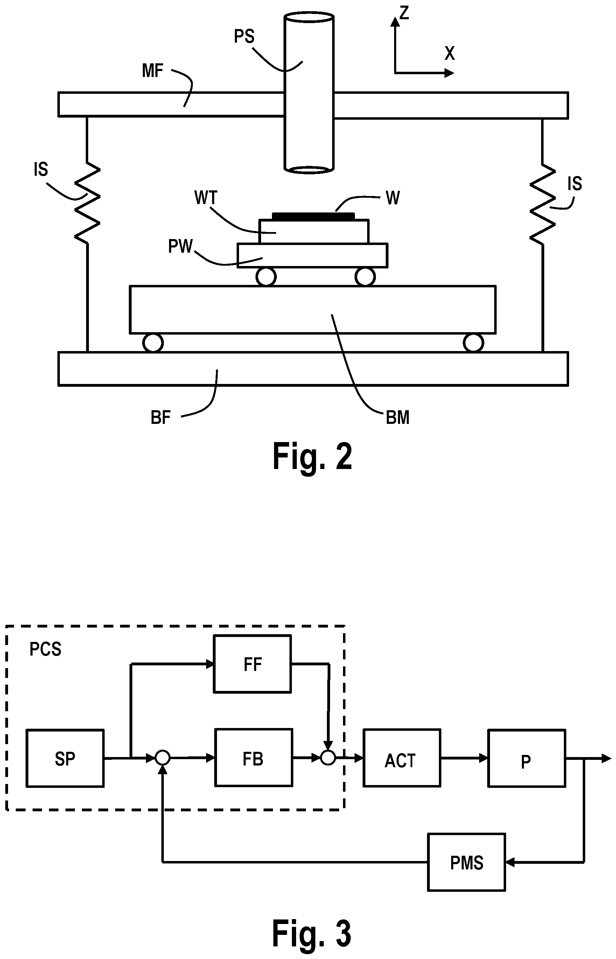

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and a sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1^{st} order, -1^{st} order, +2^{nd} order and -2^{nd} order. The encoder system optically combines the primary radiation beam and the secondary radiation beam into a combined radiation beam. A sensor in the encoder head determines a phase or phase difference of the combined radiation beam. The sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and a sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the sensor. The sensor determines a phase or a frequency of the combined radiation beam. The sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

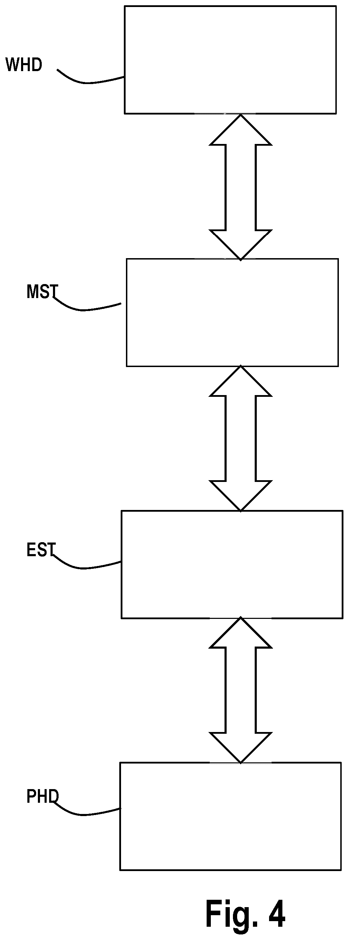

Figure 4 depicts a plurality of some of the processes that may take place in an exposure apparatus. The depicted processes comprise a substrate handling process by a substrate handler WHD, a substrate measurement process by a substrate measurement stage MST, a substrate expose process by an exposure stage EST, and patterning device handling process by a patterning device handler PHD. The exposure apparatus which performs the exposure may accordingly comprise the substrate handler, the measurement stage, the exposure stage and the patterning device handler. The processes may be performed, at least partly, simultaneously. For example, the exposure apparatus may be configured to process a lot of substrates. While one of the substrates of the lot is handled by the substrate handler, another one of the substrates of the lot is measured by the measurement stage, a further one of the substrates is exposed by the exposure stage and a patterning device is handled by a patterning device handler.

Each process of the exposure apparatus may involve the actuation of at least one actuator, which actuator may be configured to generate force and/or a torque. The actuator may for example comprise a motor. For example, the substrate handling process by the substrate handler involves actuation of a substrate handler actuator, the substrate measurement process by the measurement stage involves actuation of a measurement stage actuator, the substrate expose process by the exposure stage involves actuation of the exposure stage actuator, and the patterning device handling process by the patterning device handler involves actuation of a patterning device handler actuator.

As described above, in semiconductor manufacturing, it is desirable to increase a throughput in terms of number of substrates processed per unit of time. The increased throughput tends to translate into higher processing velocities of processing of a substrate. Due to the higher processing velocities, actuator power consumption may however tend to increase which may result in an increase in overall power consumption of the exposure apparatus.

On the other hand, it is desirable to reduce a power consumption of the exposure apparatus. Reduction of power consumption may reduce an environmental impact. Moreover, power demands on a public mains may be alleviated by a reduction of power consumption.

According to an embodiment, there is provided a substrate exposure method comprising performing, using an exposure apparatus, at least two processes simultaneously, wherein each process involves an activation of a respective actuator of the exposure apparatus, the method comprising:
- in a first phase:
   determining, for each process, if the process is time critical or non-time critical,
   determining an acceleration parameter for each actuator, comprising:
      reducing the acceleration parameter to a value lower than a respective maximum if the process is non-time critical;
- in a second phase
   adjusting an acceleration time profile for each actuator using the determined acceleration parameter for the respective actuator;
- in a third phase
   performing the at least two process by the exposure apparatus, using the adjusted acceleration time profile for each actuator.

A distinction may be made between a time critical process and a non-time critical process. The terms time critical process and non-time critical process may be understood as relative to a time slot in which the processes are to be performed. For example, the exposure apparatus may be configured to perform, within one time slot, a measurement process to measure one substrate and an exposure process to expose another substrate. Within the same time slot, further processes may take place. The process which requires the time slot in full may be understood as a time critical process. The process which may be completed in a time shorter than the time slot may be understood as a non-time critical process. Thus, the time critical process may be understood as the process which in fact determines a minimum required time length of the time slot, as the time critical process may be the process which, at full operating velocity of the processes performed by the exposure apparatus, determines the time length required for completion of the processes as the time critical process may take the longest time to be completed when being carried out at a full operating velocity.

The acceleration parameters for each process may be determined on beforehand. For example, the acceleration parameters may be determined in a lot preparation phase, i.e. may be determined before the lot of substrates is processed by the exposure apparatus.

The acceleration parameter of each process is set. For each acceleration parameter, a maximum value may be provided. The maximum value may enable the process to be executed at full operating velocity. For the non-time critical process, the acceleration parameter may be reduced to a value lower than the respective maximum value. Accordingly, an acceleration and deceleration may be reduced. In other words, the process for which the acceleration parameter is reduced may operate below full operating velocity. For example, reaching an operating velocity may take more time, due to a lower acceleration setting.

The maximum of the acceleration parameter for a process may be understood as an absolute value, i.e. applicable likewise to acceleration (rate of increase of velocity) and deceleration (rate of decrease of velocity). Similarly, the reducing the acceleration parameter to a value lower than a respective maximum may be understood as a reduction in absolute sense.

In a second phase, once the acceleration parameters have been determined, acceleration time profiles may be determined for each process, i.e. for the actuator involved in the process, a time profile may be determined. The time profile may for example determine an acceleration over time. The time profile may for example be determined in a lot processing phase, i.e. after start of the processing of the lot of substrates. The acceleration time profile may be determined using the determined acceleration parameters, i.e. taking account of the time critical processes which may require a full operating velocity, and non-time critical processes which may be performed at a lower operating velocity.

In a third phase the processes may be performed by the exposure apparatus, using the adjusted acceleration time profile for each actuator, i.e. taking account of the adjusted accceleration parameters for the non-time critical processes.

As referred to above, on the one hand, an overall power consumption of the exposure apparatus may be reduced in that accelerations by the actuators are reduced where possible, i.e. where the process is non-time critical. Reduction of the acceleration is associated with a reduction of the actuator force required by the actuator to carry out the acceleration, hence reducing an overall momentary power. On the other hand, mutual disturbances of the processes in the exposure apparatus may be reduced, in that accelerations and associated forces may be reduced. The mutual disturbances may involve mechanical disturbances by mechanical forces, as well as electrical or magnetic disturbances may involve disturbance magnetic fields, electromagnetic radiation, electrical currents, etc.

As the acceleration parameter is set to a lower value, i.e. a value lower than the maximum value for the specific actuator, the acceleration provided by the actuator on the respective part of the exposure apparatus, may be held to the lower value. As a consequence of the lower acceleration, the acceleration time profile of the actuator may exhibit a lower acceleration maximum, and accordingly it may take some more time for the actuator to accelerate to a desired velocity and/or to reach a desired position of the respective part of the exposure apparatus actuated by the acuator.

The method according to the invention may require a low compute cost to stretch non-critical profiles, as the calculation of the acceleration profiles may form a relatively low computational load. The method may provide the following benefits:

Reduced energy use per expose wafer in combination with lower acceleration, extended motor lifetime, improved dynamics / less vibrations at expose as well as less expose to measure crosstalk, more motor load reserve, allowing more marks at measure side. Overlay performance and imaging performance may be enhanced, for example as a result of less vibrations and improved dynamics, as well as due to the measurement of more marks, which may enhance alignment.

At the measure side of the exposure apparatus, a higher number of marks may be measured By reducing the acceleration at the actuation level at the expose side (e.g. non-time limiting substrate table y-axis move, or overall non-time limiting substrate table move due to dose limited recipe). The reduced substrate table acceleration at the measurement stage may imply less motor heating in the substrate table actuator(s). As a result, in a following process cycle (when the expose substrate table becomes the measure substrate table and/or vice versa) the substrate table actuator(s) may start with lower temperature and may perform higher accelerations there and hence, more mark measurements on the same substrate table may be performed (i.e. the substrate table actuator(s) may be heated up less in the expose cycle before.)

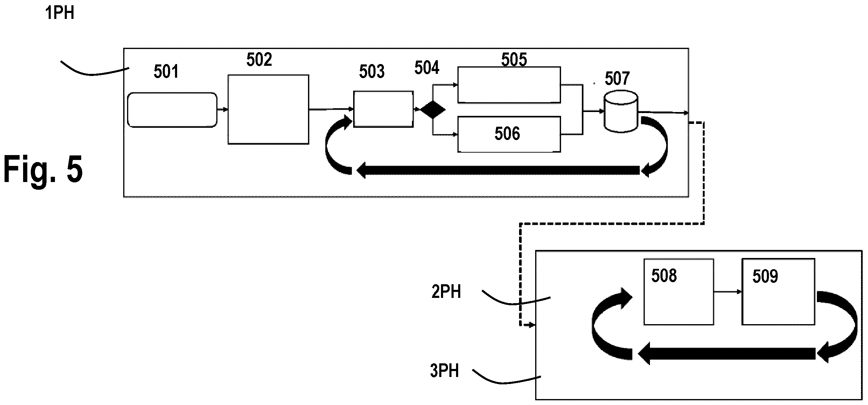

Figure 5 depicts the first phase 1PH, second phase 2PH and third phase 3PH. An example of the first, second and third phases will be described below. The first phase may for example comprise a lot preparation phase. In the lot preparation phase, a lay out recipe is received, 501, and a field layout and exposure routing are determined on the basis of the layout recipe, 502. A scan prediction is performed, 503, wherein for each field, it is determined 504 if the field is an edge field or an inner field. If the field is an edge field, an available trajectory for deceleration and acceleration, i.e. to stop and accelerate in reverse direction, may be larger, which may enable to decelerate and accelerate at a lower acceleration of the stage. For each field, a value of the acceleration parameter may be set. For the inner fields, the acceleration parameter may be set to a lower value, 505, compared to setting of the value of the acceleration parameter for the edge fields, 506. The value of the acceleration parameter may be determined for plural actuators of the exposure apparatus, for example the actuators of the substrate table long stroke and short stroke, the support of the patterning device (the mask table), the measurement stage, the substrate handler, etc. For the processes that are time critical, the respective acceleration parameter(s) may be set to the maximum value, while for the remaining processes, the respective acceleration parameter(s) may be set to a value lower than the respective maximum value of the acceleration parameter. The parameters are stored 507.

In the present example, the second phase and third phase are executed consecutively, whereby in the second phase, lot processing may be performed. Scan negotiation 508 may be performed. The term scan negotiation may be understood as determining which subsystem's actuation/move is on the critical time path (required time for the scan and step moves) and feeding the negotiated time back to the sub-systems. As a result of the scan negotiation, time critical processes may be identified. Acceleration time profiles for the actuators may be determined taking account of the acceleration parameters as determined in the first phase. As the acceleration parameters for some of the actuators may have been set to the maximum value while the acceleration parameters for the remaining actuators have been set to a value lower than the respective maximum value, the acceleration time profiles may be determined taking account of the respective values of the acceleration parameters. The acceleration time profile may be determined e.g. per field of the substrate. Once the preparations for the present field have been performed, the scan may be queued 509 and the processing of the respective field may be carried out in the third phase.

Referring to Figures 4 and 5, the processes which are determined to be time critical or non-time critical, and for which the acceleration parameters are determined, may for example be implemented in the following two different ways:
1. Multiple subsystems (e.g. wafer stage, reticle stage, Reticle mask handler), or multiple axes of the same subsystem (X, Y, etc.) have to make a "synchronous" movement, meaning that all have to make a prep(aration) and a scan movement at the same moment and with the same duration. All axes/subsystems that may perform the movement in less time than the time critical one, need to do something to "slow down" a single move to match the time of the time critical one. For turn-around moves, when range allows, this can be done by lowering the acceleration (instead of standing still at the "turn around point").
2. Multiple subsystems (e.g. wafer stage module 1, wafer stage module 2, wafer handler) have to make "individual" sequences of moves. The moves are not synchronized, but the sequences are. The sequences must start and/or end at the same time. One subsystem, the time critical sub system, needs the most time for its individual sequence. The other subsystems, i.e. the non-time critical sub systems, can slow down the whole or a part of their move sequence by lowering the acceleration to match the time of the time critical one (instead of just waiting at the end of their sequence until the time critical process has finished).

Thus, from 1. and 2. above, it follows that the processes for which the acceleration parameters are determined, may be at a level of synchronous movements or at a level of synchronous sequence of movements, i.e. the processes may comprise movements or sequences of movements. In both cases, the same or similar advantages and effects may be achieved.

In the case of synchroneous movements, e.g. movements that may be required to start and to end at a same moment in time. The time critical movements may be required to make use of the maximum acceleration, while the non-time critical movements may be performed using an acceleration lower than the maximum acceleration associated with the respective movement.

In the case of synchonous sequences of movements, the sequences of movements may be required to start and/or end at a same moment in time. The time critical sequence of movements may be required to make use of the maximum acceleration, while the non-time critical sequence of movements may be performed using an acceleration lower than the maximum acceleration associated with the respective sequence.

In an embodiment, the method further comprises, in the first phase, if the process is time critical determining if the respective actuator is time critical. Each process may involve one or more actuators. In case the process involves the actuation of plural actuators, it may be the case that only a subset of the actuators of the time critical process are time critical. For example, in case of the process of a movement of the substrate table, plural actuators may be involved, e.g. long stroke X direction and long stroke Y direction. For example, in case it is determined that only the long stroke Y direction actuator would be time critical, the long stroke X direction actuator may be set at an acceleration parameter lower than its maximum. Thus, an overall power consumption of the substrate table actuators may be reduced, even in case one of the actuators thereof appears to be time critical.

Accordingly, in the first phase, if the process is time critical and the actuator is time critical, the acceleration parameter of the actuator may be set to a respective maximum, to enable the time critical actuator of the process to operate at maximum acceleration, i.e. to enable, in the second phase, to set the acceleration time profile to include the maximum acceleration, if required. In the first phase, the acceleration parameter of the actuator may be set to a reduced value if the process is time critical and the actuator is non-time critical.

In an embodiment, the method comprises in the first phase determining a field layout and process routing of a substrate in dependence of a layout recipe of the substrate, wherein the determining for each process if the process is time critical or non-time critical takes account of the field layout and process routing. Thereby, the determination between the time critical and the non-time critical processes may take account of the processes, timing and sequence, as determined by the exposure apparatus on the basis of layout recipe parameters, among which required dose of the exposures as well as the expose layout and measure layout. These parameters may determine the scan start and end positions (and implicitly, the start and the end of the step moves in between) that the position modules may be required to perform during the processing of the substrate. The term expose layout may be understood as the positions and dimensions (x and y) of the individual fields to be exposed on the substrate. The term measure layout may be understood as the positions and type of the alignment marks to be measured on the substrate. The layout recipe may comprise a list of start and end positions of exposure scans to be performed on the substrate, and a list of alignment mark positions to be measured to align the substrate.

For example, the acceleration parameter for the non-time critical process may be decreased to a lowest possible value, e.g. to provide a maximum reduction of power consumption. The lowest possible value may be understood as the value required to be able to complete the process within the time set by the time critical actuator, i.e. the lowest possible value of the acceleration parameter for the non-time critical actuator may be determined by a time required for the time critical actuator to perform the respective process.

In an embodiment, according to the example described with reference to Figure 4, the process are selected from a substrate handler process, a substrate measure process, a substrate exposure process and a patterning device handler process.

The actuators as may be involved in the processes may be selected from an exposure stage substrate table x axis actuator, an exposure stage substrate table y axis actuator, a mask table x axis actuator, a mask table y axis actuator, a dose control actuator, a projection system actuator, a reticle mask actuator, a measurement stage substrate table x axis actuator, a measurement stage substrate table y axis actuator, a substrate handler.

In an embodiment, the method comprises determining for each field if the field is an inner field or an edge field of the substrate, and adjusting the acceleration parameter according to the determination. As referred to above, if the field is an edge field, an available trajectory for deceleration and acceleration, i.e. to stop and accelerate in reverse direction, may be larger, which may enable to decelerate and accelerate at a lower acceleration of the stage. For each field, a value of the acceleration parameter may be set. For the inner fields, the acceleration parameter may be set to a lower value compared to the value of the acceleration parameter for the edge fields. Thus, the acceleration parameter for the inner field may be set to a lower value than the acceleration parameter for the edge field. For an inner field, the acceleration parameter may be set to a value to provide that a deceleration, stop and subsequent acceleration in reverse direction are performed at a constant acceleration.

In an embodiment, for the non-time critical process, the acceleration parameter is reduced taking account of an available range of movement for the respective non-time critical process. The lower the acceleration, the higher a required range of movement may be, as for example a velocity change may require a larger distance of travel in case of a lower acceleration parameter. Taking account of the available range of movement may enable to lower the acceleration parameter as far a practicable within the available range of movement.

In an embodiment, the method further comprises in the first phase determining for each actuator a jerk parameter. Additionally to the determination of the maximum acceleration parameter for the time critical and non-time critical processes, the jerk may be limited. The term jerk is to be understood as a time derivative of the acceleration. Accordingly, a dynamic behaviour of the exposure system may be limited in the case of the non-critical process, namely by not only reducing the acceleration, however also reducing the jerk,. The jerk parameter may for example be set to a respective maximum if the process is time critical, and the jerk parameter may be set to a value lower than the maximum if the process is non-time critical.

In an embodiment, the acceleration time profile comprises a scanning setpoint profile. The setpoint profile, i.e. a setpoint time profile provides a profile of the setpoint for the actuator over time. The setpoint profile may comprise a position setpoint profile, a velocity setpoint profile, an acceleration setpoint profile and/or a jerk setpoint profile. By determining the setpoint profiles, i.e. the setpoint time profiles, relatively complex calculations associated with a simulation of the operation of the exposure apparatus when performing the processes synchroneously, may be performed on beforehand. Thus, such relatively complex calculations associated with the simulation of the operation of the exposure apparatus, i.e. the simulation of the plural processes taking place at the same time, may be performed in advance.

As illustrated above with reference to figure 5, the first phase may comprise a lot preparation phase and wherein the second phase may comprise a lot processing phase.

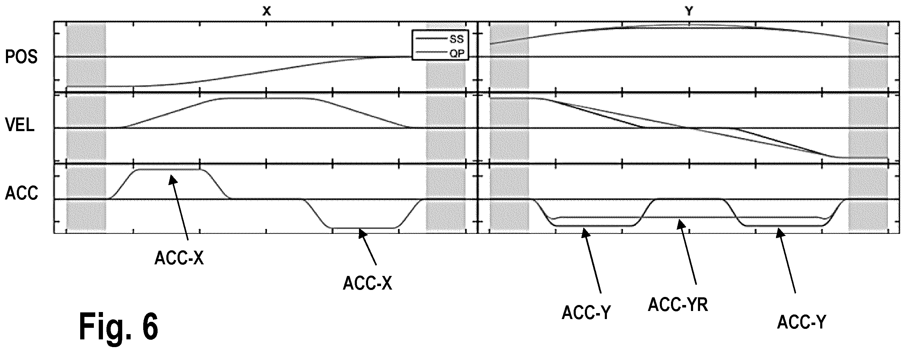

Figure 6 depicts an example of time profiles of a substrate table, namely the X-actuator and the Y-actuator thereof. The X-acuator is depicted at the left side and the Y actuator is depicted at the right side. Time is depicted along the horizontal axis and the vertical axis depicts (from top to bottom) position POS, velocity VEL and acceleration ACC.

In the X direction, the stage transitions from substantially stationary to a movement at a constant velocity, to stationary at another position in the X direction. At the change from substantially stationary towards the constant velocity, the acceleration ACC-X is positive and reaches a maximum value, at the change from the constant velocity to stationary, the acceleration ACC-X is negative and reaches a same maximum value (in absolute sense). In the substantially stationary state, the substrate table may move at a very low, varying velocity, e.g. in x direction, e.g. to compensate for imaging effects of lens heating, reticle heating, etc.

In the Y direction, the stage transitions from a movement at a constant velocity, to stationary to a movement at a constant velocity in reverse direction. At the change from the constant velocity towards stationary, the acceleration ACC-Y is negative and reaches a maximum value. At a pause (stationary) between the movement in the Y direction and the reverse movement in the Y direction, the velocity and acceleration are zero. At the change from stationary to the constant velocity in reverse direction, the acceleration ACC-Y is negative and reaches a same maximum value (in absolute sense).

In the first phase it is determined that the X movement of the substrate table is time critical while the Y movement of the substrate table appears to be non-time critical. The acceleration parameter for the X actuator is set to the maximum value thereof, while the acceleration parameter for the Y-actuator is set to a value that is reduced in respect of the maximum value. In the second phase, the time profiles of the acceleration may be determined, taking account of the reduced value for the acceleration in the Y-direction. As seen in Figure 6, the position, velocity and acceleration ACC-X in the X-direction remain substantially the same, the X-direction in the present example being time critical.

The Y-direction has been determined to be non-time critical. Accordingly, the position, velocity and acceleration in the Y-direction may be altered: the maximum value of the acceleration is lowered, causing the deceleration from the scanning velocity to stationary to be performed at a lower acceleration ACC-YR, while the acceleration from stationary to the scanning velocity in reverse direction is likewise performed at the lower acceleration ACC-YR. In fact, as depicted in figure 6, the acceleration remains at the lower, constant level during deceleration to stop and acceleration in the reverse direction, providing for a more smooth drive of the actuator in the Y direction, i.e. a more smooth drive of the motor of the stage in the Y direction.

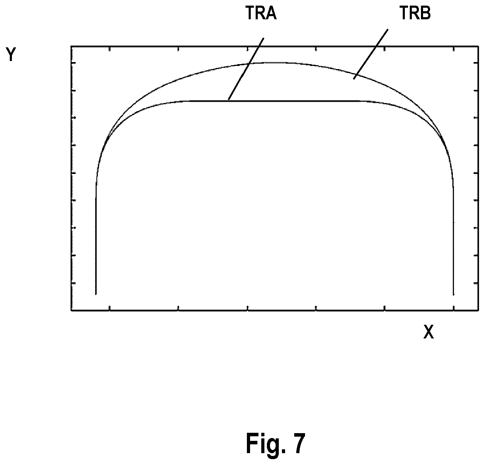

An enlarged view of the position trajectory associated with the processes described with reference to Figure 6 is depicted in Figure 7. Figure 7 depicts the conventional profile and the profile according to the invention. The conventional trajectory TRA provides for
- a scanning movement in Y direction,
- a deceleration in Y, stop in Y and acceleration in Y in the reverse scanning direction, whereby the substrate table moves in X direction, e.g. to a following row, and
- a scanning movement in Y direction.

A trajectory TRB using a lower acceleration parameter (i.e. a less pronounced deceleration and acceleration in the Y direction) is depicted in Figure 7. As seen in Figure 7, due to the lower rate of deceleration and acceleration in reverse direction in the Y direction, some additional space for movement in Y direction is used, as the lower accelerations in Y direction require some more space before standstill and before reaching the scanning velocity in the opposite direction.

According to a further embodiment of the invention, there is provided an exposure apparatus configured to perform at least two processes simultaneously, wherein each process involves an activation of a respective actuator of the exposure apparatus, the exposure apparatus comprising a control device configured to:
- in a first phase:
   determine, for each process, if the process is time critical or non-time critical,
   determine an acceleration parameter for each actuator, comprising:
      reduce the acceleration parameter to a value lower than a respective maximum if the process is non-time critical;
         - in a second phase
      adjust an acceleration time profile for each actuator using the determined acceleration parameter for the respective actuator;
         - in a third phase
      perform the processes by the exposure apparatus, using the adjusted acceleration time profile for each actuator.

With the exposure apparatus according to the invention, the same or similar effects and advantages may be achieved with the method according to the invention. Furthermore, the same or similar embodiments as described with reference to the method according to the invention may apply to the exposure apparatus according to the invention, providing the same or similar advantages and effects.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Other aspects of the invention are set-out as in the following numbered clauses.
1. A substrate exposure method, the method comprising performing, using an exposure apparatus, at least two processes simultaneously, wherein each process involves an activation of a respective actuator of the exposure apparatus, the method comprising:
   - in a first phase:
      determining, for each process, if the process is time critical or non-time critical,
      determining an acceleration parameter for each actuator, comprising:
         reducing the acceleration parameter to a value lower than a respective maximum if the process is non-time critical;
   - in a second phase
      adjusting an acceleration time profile for each actuator using the determined acceleration parameter for the respective actuator;
   - in a third phase
      performing the at least two processes by the exposure apparatus, using the adjusted acceleration time profile for each actuator.
2. The method according to clause 1, further comprising, in the first phase, if the process is time critical determining if the respective actuator is time critical.
3. The method according to clause 2, further comprising, in the first phase, setting the acceleration parameter of the actuator to a respective maximum if the process is time critical and the actuator is time critical.
4. The method according to clause 2 or 3, further comprising, in the first phase, setting the acceleration parameter of the actuator to a reduced value if the process is time critical and the actuator is non-time critical.
5. The method according to any one of the preceding clauses, comprising in the first phase determining a field layout and process routing of a substrate in dependence of a layout recipe of the substrate, wherein the determining for each processes if the process is time critical or non-time critical takes account of the field layout and process routing.
6. The method according to any one of the preceding clauses, wherein the acceleration parameter for the non-time critical process is decreased to a lowest possible value.
7. The method according to clause 6, wherein the lowest possible value of the acceleration parameter for the non-time critical actuator is determined by a time required for the time critical actuator to perform the respective process.
8. The method according to any one of the preceding clauses, wherein the processes are selected from a substrate handler process, a substrate measure process, a substrate exposure process and a patterning device handler process.
9. The method according to any one of the preceding clauses, wherein the actuators are selected from an exposure stage substrate table x axis actuator, an exposure stage substrate table y axis actuator, a mask table x axis actuator, a mask table y axis actuator, a dose control actuator, a projection system actuator, a reticle mask actuator, a measurement stage substrate table x axis actuator, a measurement stage substrate table y axis actuator, a substrate handler.
10. The method according to any one of the preceding clauses, comprising determining for each field if the field is an inner field or an edge field of the substrate, and adjusting the acceleration parameter according to the determination.
11. The method according to clause 10, wherein the acceleration parameter for the inner field is set to a lower value than the acceleration parameter for the edge field.
12. The method according to clause 11, wherein for an inner field the acceleration parameter is set to a value to provide that a deceleration, stop and subsequent acceleration in reverse direction are performed at a constant acceleration.
13. The method according to any one of the preceding clauses, wherein, for the non-time critical process, the acceleration parameter is reduced taking account of an available range of movement for the respective process.
14. The method according to any one of the preceding clauses, further comprising in the first phase determining for each actuator a jerk parameter.
15. The method according to clause 14, comprising setting the jerk parameter to a respective maximum if the process is time critical, and reducing the jerk parameter to a value lower than the maximum if the process is non-time critical.
16. The method according to any one of the preceding clauses, wherein the acceleration time profile comprises a scanning setpoint profile.
17. The method according to any one of the preceding clauses, wherein the first phase comprises a lot preparation phase and wherein the second phase comprises a lot processing phase.
18. An exposure apparatus configured to perform at least two processes simultaneously, wherein each process involves an activation of a respective actuator of the exposure apparatus, the exposure apparatus comprising a control device configured to:
   - in a first phase:
      determine, for each process, if the process is time critical or non-time critical,
      determine an acceleration parameter for each actuator, comprising:
         reduce the acceleration parameter to a value lower than a respective maximum if the process is non-time critical;
   - in a second phase
      adjust an acceleration time profile for each actuator using the determined acceleration parameter for the respective actuator;
   - in a third phase
      perform the at least two processes by the exposure apparatus, using the adjusted acceleration time profile for each actuator.
19. The exposure apparatus according to clause 18, wherein the control device is configured to, in the first phase, if the process is time critical determine if the respective actuator is time critical.
20. The exposure apparatus according to clause 19, wherein the control device is configured to, in the first phase, set the acceleration parameter of the actuator to a respective maximum if the process is time critical and the actuator is time critical.
21. The exposure apparatus according to clause 19 or 20, wherein the control device is configured to, in the first phase, set the acceleration parameter of the actuator to a reduced value if the process is time critical and the actuator is non-time critical.
22. The exposure apparatus according to any one of clauses 18 - 21, wherein the control device is configured to in the first phase determine a field layout and process routing of a substrate in dependence of a layout recipe of the substrate, wherein the determine for each processes if the process is time critical or non-time critical takes account of the field layout and process routing.
23. The exposure apparatus according to any one of clauses 18 - 22, wherein the control device is configured to decrease the acceleration parameter for the non-time critical process to a lowest possible value.
24. The exposure apparatus according to clause 23, wherein the control device is configured to determine the lowest possible value of the acceleration parameter for the non-time critical actuator by a time required for the time critical actuator to perform the respective process.
25. The exposure apparatus according to any one of clauses 18 - 24, wherein the control device is configured to select the processes from a substrate handler process, a substrate measure process, a substrate exposure process and a patterning device handler process.
26. The exposure apparatus according to any one of clauses 18 - 25, wherein the control device is configured to select the actuators from an exposure stage substrate table x axis actuator, an exposure stage substrate table y axis actuator, a mask table x axis actuator, a mask table y axis actuator, a dose control actuator, a projection system actuator, a reticle mask actuator, a measurement stage substrate table x axis actuator, a measurement stage substrate table y axis actuator, a substrate handler.
27. The exposure apparatus according to any one of clauses 18 - 26, wherein the control device is configured to determine for each field if the field is an inner field or an edge field of the substrate, and adjust the acceleration parameter according to the determination.
28. The exposure apparatus according to clause 27, wherein the control device is configured to set the acceleration parameter for the inner field to a lower value than the acceleration parameter for the edge field.
29. The exposure apparatus according to clause 28, wherein the control device is configured to set for an inner field the acceleration parameter to a value to provide that a deceleration, stop and subsequent acceleration in reverse direction are performed at a constant acceleration.
30. The exposure apparatus according to any one of clauses 18 - 29, wherein the control device is configured to, for the non-time critical process, reduce the acceleration parameter taking account of an available range of movement for the respective process.
31. The exposure apparatus according to any one of clauses 18 - 30, wherein the control device is configured to determine in the first phase for each actuator a jerk parameter.
32. The exposure apparatus according to clause 31, wherein the control device is configured to set the jerk parameter to a respective maximum if the process is time critical, and reduce the jerk parameter to a value lower than the maximum if the process is non-time critical.
33. The exposure apparatus according to any one of clauses 18 - 32, wherein the acceleration time profile comprises a scanning setpoint profile.
34. The exposure apparatus according to any one of clauses 18 - 33, wherein the first phase comprises a lot preparation phase and wherein the second phase comprises a lot processing phase.

## Claims

1. An exposure apparatus configured to perform at least two processes simultaneously, wherein each process involves an activation of a respective actuator of the exposure apparatus, the exposure apparatus comprising a control device configured to:
- in a first phase:
determine, for each process, if the process is time critical or non-time critical,
determine an acceleration parameter for each actuator, comprising:
reduce the acceleration parameter to a value lower than a respective maximum if the process is non-time critical;
- in a second phase
adjust an acceleration time profile for each actuator using the determined acceleration parameter for the respective actuator;
- in a third phase
perform the at least two processes by the exposure apparatus, using the adjusted acceleration time profile for each actuator.

2. The exposure apparatus according to claim 1, wherein the control device is configured to, in the first phase, if the process is time critical determine if the respective actuator is time critical.

3. The exposure apparatus according to claim 2, wherein the control device is configured to, in the first phase, set the acceleration parameter of the actuator to a respective maximum if the process is time critical and the actuator is time critical.

4. The exposure apparatus according to claim 2 or 3, wherein the control device is configured to, in the first phase, set the acceleration parameter of the actuator to a reduced value if the process is time critical and the actuator is non-time critical.

5. The exposure apparatus according to any one of claims 1 - 4, wherein the control device is configured to in the first phase determine a field layout and process routing of a substrate in dependence of a layout recipe of the substrate, wherein the determine for each processes if the process is time critical or non-time critical takes account of the field layout and process routing.

6. The exposure apparatus according to any one of claims 1 - 5, wherein the control device is configured to decrease the acceleration parameter for the non-time critical process to a lowest possible value.

7. The exposure apparatus according to claim 6, wherein the control device is configured to determine the lowest possible value of the acceleration parameter for the non-time critical actuator by a time required for the time critical actuator to perform the respective process.

8. The exposure apparatus according to any one of claims 1 - 7, wherein the control device is configured to select the processes from a substrate handler process, a substrate measure process, a substrate exposure process and a patterning device handler process.

9. The exposure apparatus according to any one of claims 1 - 8, wherein the control device is configured to determine for each field if the field is an inner field or an edge field of the substrate, and adjust the acceleration parameter according to the determination.

10. The exposure apparatus according to any one of claims 1 - 9, wherein the control device is configured to, for the non-time critical process, reduce the acceleration parameter taking account of an available range of movement for the respective process.

11. The exposure apparatus according to any one of claims 1 - 10, wherein the acceleration time profile comprises a scanning setpoint profile.

12. The exposure apparatus according to any one of claims 1 - 11, wherein the first phase comprises a lot preparation phase and wherein the second phase comprises a lot processing phase.

13. An substrate exposure method, the method comprising performing, using an exposure apparatus, at least two processes simultaneously, wherein each process involves an activation of a respective actuator of the exposure apparatus, the method comprising:
- in a first phase:
determining, for each process, if the process is time critical or non-time critical,
determining an acceleration parameter for each actuator, comprising:
reducing the acceleration parameter to a value lower than a respective maximum if the process is non-time critical;
- in a second phase
adjusting an acceleration time profile for each actuator using the determined acceleration parameter for the respective actuator;
- in a third phase
performing the at least two processes by the exposure apparatus, using the adjusted acceleration time profile for each actuator.

14. The method according to claim 13, further comprising, in the first phase, if the process is time critical determining if the respective actuator is time critical.

15. The method according to claim 14, further comprising, in the first phase, setting the acceleration parameter of the actuator to a respective maximum if the process is time critical and the actuator is time critical.
